# FASCICULE DE BREVET EUROPEEN

(11) **EP 2 212 907 B1**
(45) Date de publication et mention de la délivrance du brevet: **18.06.2014**
(21) Numéro de dépôt: 08858110.3
(22) Date de dépôt: 17.11.2008
(51) Int. Cl.: H01L 21/311, H01L 21/3213, H01L 21/306, C23F 1/08, C23F 1/18

(54) **PROCEDE ET DISPOSITIF DE GRAVURE SELECTIVE**
VERFAHREN UND VORRICHTUNG ZUM SELEKTIVEN ÄTZEN
METHOD AND DEVICE FOR SELECTIVE ETCHING

(30) Priorité: 20.11.2007 FR 0759179
(43) Date de publication de la demande: 04.08.2010
(73) Titulaire: Institut Polytechnique de Grenoble, 38031 Grenoble Cedex (FR); Université Joseph Fourier, 38400 St Martin d'Hères (FR)
(72) Inventeur: BAILLET, Francis, F-38850 Paladru (FR); GONDREXON, Nicolas, F-38240 Meylan (FR)
(74) Mandataire: Dossmann, Gérard
(86) Numéro de dépôt international: PCT/FR2008/052069
(87) Numéro de publication internationale: WO 2009/071788

(56) Documents cités:
- EP-A- 0 844 650
- US-A- 4 554 046
- US-A1- 2004 053 503
- US-B2- 6 746 967
- LUCEY M S: "300 mm megasonic cleaning process to address material consumption requirements for sub-65nm" 15 avril 2005 (2005-04-15), MICROELECTRONICS AND ELECTRON DEVICES, 2005. WMED '05. 2005 IEEE WORKS HOP ON BOISE, ID, USA APRIL 15, 2005, PISCATAWAY, NJ, USA,IEEE, PAGE(S) 21 - 23 , XP010798764 ISBN: 978-0-7803-9072-0 figure 1
- DATABASE INSPEC THE INSTITUTION OF ELECTRICAL ENGINEERS, STEVENAGE, GB; Inspec No. 9001583 WOO SEONG CHE ET AL: "The improvement of wet anisotropic etching with megasonic wave" XP002483540

## Description

La présente invention concerne le domaine de la gravure d'un matériau.

La présente invention peut concerner plus particulièrement le domaine de la fabrication des composants semiconducteurs, dans lequel il est généralement prévu, en cours de fabrication, de nombreuses étapes sélectives de gravure d'un matériau par rapport à un autre ou d'autres, le domaine de la récupération de tranches semiconductrices comportant des défauts, dans lequel, on veut éliminer une couche superficielle pour récupérer un substrat sous-jacent, éventuellement déjà muni d'un certain nombre de couches conformées de façon appropriée, et le domaine de l'amélioration de l'état de surface d'une couche d'un matériau

De façon générale, quand on veut éliminer une couche déposée sur un substrat, de façon sélective par rapport à une autre couche, après avoir éventuellement masqué une partie de la couche à éliminer si on veut n'en éliminer qu'une partie, deux procédés principaux existent dans le domaine de la fabrication des composants semiconducteurs.

La première famille de procédés consiste en une attaque «humide» dans laquelle on immerge la structure dont on veut attaquer une couche dans un produit de gravure, typiquement à base d'acide chlorhydrique ou fluorhydrique. Plusieurs mélanges ont été développés pour permettre une attaque sélective d'une couche par rapport à une autre, par exemple une couche d'oxyde de silicium par rapport à une couche de nitrure de silicium, une couche d'oxyde de silicium par rapport à du silicium, une couche d'un métal par rapport à une couche d'isolant.

Dans cette famille, le document US-A- 6 746 967 décrit un procédé d'oxydation du nickel dans une solution oxydante à PH contrôlé. Simplement pour accélérer l'oxydation, la présence d'ultrasons basse fréquence modifie la barrière énergétique nécessaire l'attaque du nickel par la solution.

La seconde famille de procédés, appelée attaque "sèche", consiste à placer la structure portant la couche à éliminer dans un plasma contenant des agents de gravure, par exemple des radicaux actifs de chlore, de fluor, d'oxygène, etc.

La seconde famille de procédés présente de nombreux avantages par rapport à la première, notamment du fait qu'elle permet des attaques anisotropes, et qu'elle présente souvent une meilleure sélectivité de gravure entre deux matériaux. Toutefois, elle présente l'inconvénient de nécessiter des appareillages complexes et, dans le cas où la couche à graver est portée par une tranche de silicium, de ne permettre de traiter qu'une ou deux tranches de silicium à la fois. Par contre, la première famille de procédés, bien que souvent impossible à mettre en oeuvre quand on veut procéder à des attaques fortement sélectives d'un matériau par rapport à un autre matériau, présente l'avantage de permettre des traitements par lots, de nombreuses plaquettes pouvant être disposées dans une nacelle puis immergées dans la solution de gravure.

Diverses variantes de ces deux familles de procédés sont connues de l'homme de métier. Par exemple, en ce qui concerne le procédé de gravure «humide», on propose parfois pour améliorer le résultat d'appliquer un champ électrique entre le matériau à graver et la solution de gravure.

Une troisième famille de procédés, plus généralement utilisée pour le nettoyage, le dégraissage de surfaces, consiste à plonger la surface dans un bain de nettoyage, par exemple de l'alcool, et à appliquer au milieu liquide des vibrations acoustiques à des fréquences acoustiques relativement basses, couramment de l'ordre de 20 à 45 kHz. Alors, les vibrations aident à décoller les particules de salissure de la surface à nettoyer.

Par ailleurs, dans les procédés de gravure «humide», on utilise couramment des mélangeurs pour faire circuler le liquide de gravure sur la surface du matériau à graver et éventuellement des ondes acoustiques basse fréquence, entre 1 à 40 kHz, pour améliorer le mélange. Par exemple, dans le document US-A- 4 544 066, la solution est agitée par des ultrasons basse fréquence pour uniformiser la réaction sur la surface.

La présente invention a pour objet un procédé de gravure sélective d'une structure comprenant au moins un premier matériau à graver et au moins un second matériau.

Selon l'invention, ce procédé comprend les étapes suivantes :
- choisir au moins une espèce chimique apte à réagir avec le premier matériau et à ne pas réagir avec le second matériau,
- choisir au moins un composé soluble qui ne réagit pas avec lesdits matériaux mais qui est apte à libérer l'espèce chimique précitée,
- réaliser une solution contenant ledit composé,
- immerger la structure dans la solution,
- et produire dans la solution des ultrasons à au moins une fréquence apte à générer des bulles de cavitation telles que l'espèce chimique est générée et réagit sélectivement avec le premier matériau en produisant un composé soluble ou un précipité.

Selon l'invention, la fréquence des ultrasons peut être comprise entre 100 kHz et 3 MHz.

Selon l'invention, la fréquence des ultrasons peut être comprise entre 200 kHz et 600 kHz.

Selon l'invention, la solution peut être à une concentration inférieure à cinq moles par litre.

Selon l'invention, la durée de la production des ultrasons peut être déterminée pour éliminer le premier matériau en totalité.

Selon l'invention, la durée de la production des ultrasons peut être déterminée pour éliminer le premier matériau à partir de surfaces découvertes de ce dernier.

Selon l'invention, la durée de la production des ultrasons peut être déterminée pour réduire la rugosité de surface du premier matériau.

Selon l'invention, la durée de la production des ultrasons peut être déterminée pour réduire l'épaisseur du premier matériau.

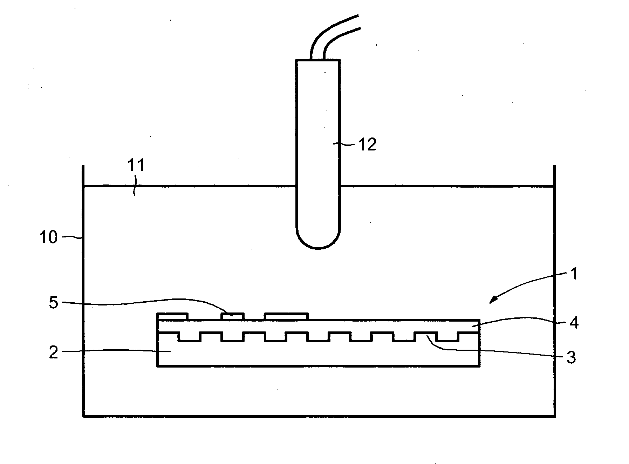

La présente invention va maintenant être exposée plus en détail par la description de modes de réalisation particuliers, à titre d'exemples non limitatifs en relation avec l'appareillage de gravure de la figure unique annexée.

### Exemple 1.

Sur la figure, on a représenté une structure en forme de plaquette 1 comprenant une tranche de silicium 2 revêtue d'une couche isolante, par exemple une couche d'oxyde de silicium 3 gravée selon un certain motif pour présenter des inégalités d'épaisseur, par exemple en damier, et revêtue d'une couche de cuivre 4. De façon courante, en pratique, une couche intermédiaire d'accrochage, par exemple une couche de nitrure de titane TiN est disposée à l'interface entre la couche d'oxyde 2 et la couche de cuivre 3.

A titre d'exemple d'ordre de grandeur, la plaquette de silicium 1 peut présenter une épaisseur de plusieurs centaines de µm, la couche d'oxyde 2 peut présenter une épaisseur inférieure à 25 µm et par exemple une épaisseur inférieure à 0,1 µm dans ses parties les plus fines, et la couche de cuivre peut présenter une épaisseur de l'ordre de 1 µm.

Dans une variante représentée sur la partie droite de la plaquette, on cherche à éliminer totalement la couche de cuivre 3, pour récupérer le substrat sous-jacent.

Selon une autre variante représentée sur la partie gauche de la plaquette, on cherche à éliminer localement une partie de la couche 3 non protégée par un masque 5 pour réaliser une étape intermédiaire de fabrication d'un dispositif semiconducteur.

Pour graver la couche de cuivre 4, on immerge la plaquette 1 contenant une solution ou bain 11 contenue dans une enceinte 10 et on active un émetteur d'ultrasons 12 ou autre source d'ondes acoustiques haute fréquence, introduit dans la solution 11.

On choisit une solution contenant des molécules n'attaquant ni le cuivre ni le silicium ni le masque et susceptibles de libérer une espèce chimique apte à réagir avec le cuivre, sans que cette espèce chimique ne réagisse avec le silicium et avec le matériau constituant le masque.

On choisit des ondes acoustiques haute fréquence apte à générer des bulles de cavitation, c'est-à-dire des ondes acoustiques ayant une fréquence supérieure à 100 kHz, par exemple comprise entre 100 kHz et 3 MHz, de préférence entre 200 kHz et 3 MHz, et encore de préférence de l'ordre de 200 à 600 kHz. Dans ces plages de fréquences, la taille des bulles de cavitation peut atteindre des valeurs de l'ordre de 1 µm pour des fréquences de l'ordre de 400 kHz et diminue encore jusqu'à des valeurs de l'ordre de 0,1 µm pour des fréquences de l'ordre de 1 MHz.

Selon un exemple particulier, pour attaquer la couche 4 de cuivre, on peut choisir une solution d'HCl à une mole par litre et on peut choisir un émetteur d'ultrasons 12 fournissant des ondes acoustiques à une fréquence de l'ordre de 400 kHz et à une puissance de l'ordre de 300 watts.

Dans ces conditions, des bulles de cavitation à durée très courte, dans lesquelles les pressions peuvent atteindre des valeurs de l'ordre de plusieurs atmosphères et les températures peuvent avoisiner plusieurs milliers de degrés, sont générées, notamment et plus particulièrement à la surface de la plaquette 1, et engendrent la formation de l'espèce chimique Cl° à partir des molécules d'HCl. L'espèce chimique Cl° engendrée réagit avec le cuivre en produisant du CuCl ou du CuCl₂.

Il convient de noter que la gravure obtenue est bien spécifique au phénomène de création de l'espèce chimique active Cl°. En effet, du cuivre en contact avec une solution d'HCl de même concentration ne réagit pas, même en présence d'une agitation créée par un émetteur d'ultrasons à basse fréquence, par exemple à 40 kHz.

Pour les épaisseurs indiquées ci-dessus, après une exposition de quelques minutes, on obtient une élimination complète de la couche 4 de cuivre métallique, totalement ou localement, sans attaque ou gravure de la couche 3 de d'oxyde de silicium, c'est-à-dire sans gravure qui pourrait être supérieure à environ un nanomètre.

### Exemple 2.

Disposant d'une plaquette de silicium portant une couche d'oxyde de silicium, on cherche à éliminer cette couche d'oxyde de silicium.

On place cette plaquette dans une solution de NaOH (soude) à 1 mole par litre et on émet dans cette solution des ondes acoustiques à une fréquence de l'ordre de 400 kHz et à une puissance de l'ordre de 300 watts.

Dans ces conditions, comme dans l'exemple précédent, des bulles de cavitation générées dans la solution, notamment et plus particulièrement à la surface de la plaquette, engendrent la formation de l'espèce chimique OH°, à partir des molécules NaOH. L'espèce chimique OH° engendrée réagit avec l'oxyde de silicium en produisant du Na₂SiO₄.

Après quelques minutes, la couche d'oxyde de silicium est éliminée, sans aucune attaque du silicium sous-jacent.

On peut aussi noter qu'en l'absence des ondes acoustiques à la fréquence indiquée, l'oxyde de silicium n'est pas attaqué par la soude.

### Exemple 3.

Disposant d'une plaquette de silicium portant une couche de cuivre comme dans l'exemple I ou une couche d'oxyde de silicium comme dans l'exemple 11, on cherche à réduire la rugosité de la surface de cette couche.

Pour cela, on peut mettre en oeuvre par exemple respectivement les conditions de l'exemple 1 ou de l'exemple 11, mais on limite la durée d'action de l'émetteur à ultrasons à une durée, par exemple quelques secondes, telle que seule la matière constituant les rugosités ou aspérités est attaquée au moins partiellement.

L'attaque des rugosités est d'autant plus efficace que la densité des bulles de cavitation est plus importante à l'extrémité de ces rugosités ou aspérités.

### Exemple 4.

Disposant d'une plaquette présentant une couche de cuivre comme dans l'exemple 1 ou une couche d'oxyde de silicium comme dans l'exemple II, on cherche à réduire l'épaisseur de cette couche.

Pour cela, on peut mettre en oeuvre par exemple les conditions de l'exemple 1 ou de l'exemple II, mais on limite et on contrôle la durée d'action de l'émetteur à ultrasons, de telle sorte que l'épaisseur restante de la couche atteigne une valeur souhaitée.

Considérant les exemples qui précèdent, la présente invention s'applique de façon générale à la gravure sélective d'un premier matériau par rapport à un second matériau, d'une structure, en prenant les dispositions suivantes.

On choisit une espèce chimique apte à réagir avec le premier matériau à graver et à ne pas réagir avec le second matériau.

On choisit un composé soluble qui n'attaque pas ces matériaux et apte à libérer l'espèce chimique sélectionnée.

Ayant réalisé une solution contenant ce composé et ayant immergé la structure dans la solution, on produit dans la solution des ultrasons à une fréquence apte à générer des bulles de cavitation.

Il en résulte que les bulles de cavitation, dans lesquelles les pressions atteignent des valeurs de l'ordre de plusieurs atmosphères et la température avoisine plusieurs milliers de degrés, engendre la production, dans la solution et notamment au voisinage de la surface solide à traiter, de l'espèce chimique choisie, qui réagit sélectivement avec le premier matériau en produisant un composé soluble ou un précipité, sans attaquer le second matériau. On peut considérer qu'il existe une certaine équivalence entre ce qui vient d'être décrit et certains plasmas.

Pour effectuer le choix de l'espèce chimique adaptée et du composé soluble adapté, l'homme de l'art saura utiliser par exemple le logiciel "facstage" contenant la base de données européenne SGTE pour déterminer une espèce chimique susceptible de réagir avec un premier matériau pour produire un composé soluble ou facilement effritable ou un précipité, cette espèce chimique ne réagissant pas avec un second matériau.

La base de données SGTE n'est pas la seule base de données thermodynamique à la disposition de l'homme de l'art. D'autres bases existent telles que par exemple le logiciel "thermocalc". Pour avoir accès au logiciel "thermocalc" ou au logiciel "factsage", il suffit de se connecter sur les sites Internet suivants : http://www.thermocalc.com ; www.factsage.com ; www.gtt-technologies.com

Ces bases servent de support à des logiciels qui, par minimisation d'énergie de Gibbs, sont capables de donner les composés thermodynamiquement stables qui se formeront par réaction chimique à partir d'un mélange de départ donné. Par thermodynamiquement stable, on entend un produit qui serait obtenu après un temps de réaction infini. On peut par exemple observer ce qui suit.
- un mélange de départ silice + cuivre solide + HCl dilué à 1 Mole par litre n'évolue pas (reste stable). Si on ajoute dans le calcul qu'il existe en solution des radicaux Cl°, le cuivre solide se transformera totalement en Cu(OH)₂ et Cu²⁺ mais la silice n'évoluera pas.
- un mélange de départ de silicium + silice et de soude à 1 mole par litre est un mélange thermodynamiquement stable (pas d'évolution). Si l'on ajoute au calcul que l'on va former en solution les espèces chimiques OH° ou Na°, le logiciel de thermodynamique montre que la silice sera transformée en composé H₄SiO₄ solide alors que le silicium restera stable.

L'homme de l'art saura déterminer quelles espèces chimiques peuvent se former dans une solution donnée et tester, en utilisant les logiciels susmentionnés, quelles phases (composés ou corps purs) seront stables en solution et lesquelles évolueront par réaction chimique.

On peut noter les exemples suivants, pour le choix d'une espèce chimique destinée à graver un premier matériau sans attaquer un second matériau d'une plaquette.

L'espèce chimique OH° peut être active pour attaquer ou graver Si, sans attaquer SiGe.

L'espèce chimique H° peut être active pour graver InSnO₃, sans attaquer SiO₂.

L'espèce chimique Cl° peut être active pour attaquer ou graver Cu, sans attaquer SiO₂.

L'espèce chimique F° peut être active pour attaquer ou graver Si, sans attaquer un polymère.

L'espèce chimique Cl° peut être active pour attaquer ou graver Au, sans attaquer une céramique AIN.

L'espèce chimique OH° ou l'espèce chimique Cl° peut être active pour attaquer ou graver Al, sans attaquer Al₂O₃.

L'espèce chimique OH° peut être active pour attaquer ou graver W, sans attaquer Al₂O₃.

L'espèce chimique Cl° peut être active pour attaquer ou graver Cu, sans attaquer SiO₂ ou une céramique TiN.

L'espèce chimique H° ou l'espèce chimique Cl° peut être active pour attaquer ou graver InSnO₂, sans attaquer un polymère ou un verre.

L'espèce chimique Na° ou l'espèce chimique F° peut être active pour attaquer ou graver SiO₂, sans attaquer Al.

L'espèce chimique H° ou l'espèce chimique F° peut être active pour attaquer ou graver Al₂O₃, sans attaquer W.

L'espèce chimique Br° peut être active pour attaquer ou graver TiN, sans attaquer SiO₂.

L'espèce chimique K° peut être active pour attaquer ou graver Si₃N₄, sans attaquer SiO ou un polymère.

L'espèce chimique Cl° peut être active pour attaquer ou graver une céramique TaN, sans attaquer SiO₂.

Par ailleurs, l'homme de l'art saura, par des essais simples, déterminer dans chaque cas particulier la concentration de la solution choisie, la fréquence optimale et la puissance optimale des ultrasons pour que l'effet des bulles de cavitation produites engendre l'attaque souhaitée, ainsi que la durée du traitement à appliquer au premier matériau à graver.

Parmi les avantages de la présente invention, on notera la grande simplicité du dispositif de mise en oeuvre, et le fait que l'on peut traiter simultanément dans un même bain un lot de tranches.

Dans un autre exemple, la présente invention peut être utilisée pour nettoyage de pointes de contact électrique, en particulier l'attaque chimique de particules d'aluminium déposées sur des pointes en tungstène utilisées pour effectuer le test de puces électroniques.

Un autre avantage de la présente invention réside dans le fait que les solutions utilisées sont de faibles concentrations et donc peu nocives et ne posent pas ou peu de problèmes d'environnement.

Par ailleurs, en complément des ultrasons, on pourrait par exemple appliquer un champ électrique entre le matériau à graver et la solution de gravure pour modifier le traitement.

## Revendications

1. Procédé de gravure sélective d'une structure (1) comprenant au moins un premier matériau à graver (4) et au moins un second matériau (2), comprenant les étapes suivantes :
- choisir au moins une espèce chimique apte à réagir avec le premier matériau (4) et à ne pas réagir avec le second matériau (3),
- choisir au moins un composé soluble qui ne réagit pas avec lesdits matériaux mais qui est apte à libérer l'espèce chimique précitée,
- réaliser une solution (11) contenant ledit composé,
- immerger la structure (1) dans la solution,
- et produire dans la solution des ultrasons à au moins une fréquence apte à générer des bulles de cavitation telles que l'espèce chimique est générée et réagit sélectivement avec le premier matériau en produisant un composé soluble ou un précipité.

2. Procédé selon la revendication 1, dans lequel la fréquence des ultrasons est comprise entre 100 kHz et 3 MHz.

3. Procédé selon la revendication 1, dans lequel la fréquence des ultrasons est comprise entre 200 kHz et 600 kHz.

4. Procédé selon la revendication 1, dans lequel la solution est à une concentration inférieure à cinq moles par litre.

5. Procédé selon la revendication 1, dans lequel la durée de la production des ultrasons est déterminée pour éliminer le premier matériau en totalité.

6. Procédé selon la revendication 1, dans lequel la durée de la production des ultrasons est déterminée pour éliminer le premier matériau à partir de surfaces découvertes de ce dernier.

7. Procédé selon la revendication 1, dans lequel la durée de la production des ultrasons est déterminée pour réduire la rugosité de surface du premier matériau.

8. Procédé selon la revendication 1, dans lequel la durée de la production des ultrasons est déterminée pour réduire l'épaisseur du premier matériau.

## Patentansprüche

1. Verfahren zum gezielten Ätzen einer Struktur (1), die mindestens ein erstes zu ätzendes Material (4) und mindestens ein zweites Material (2) umfasst, umfassend die folgenden Schritte:
- Wählen mindestens einer chemischen Spezies, die geeignet ist, mit dem ersten Material (4) zu reagieren und nicht mit dem zweiten Material (3) zu reagieren,
- Wählen mindestens einer löslichen Verbindung, die nicht mit den Materialien reagiert, die jedoch geeignet ist, die oben genannte chemische Spezies freizusetzen,
- Herstellen einer Lösung (11), die die Verbindung enthält,
- Eintauchen der Struktur (1) in die Lösung,
- und Erzeugen von Ultraschall in der Lösung mit mindestens einer Frequenz, die geeignet ist, Kalitationsblasen zu erzeugen, so dass die chemische Spezies erzeugt wird und unter Erzeugung einer löslichen Verbindung oder eines Niederschlags gezielt mit dem ersten Material reagiert.

2. Verfahren nach Anspruch 1, wobei die Frequenz des Ultraschalls zwischen 100 kHz und 3 MHz liegt.

3. Verfahren nach Anspruch 1, wobei die Frequenz des Ultraschalls zwischen 200 kHz und 600 kHz liegt.

4. Verfahren nach Anspruch 1, wobei die Konzentration der Lösung weniger als fünf Mol pro Liter beträgt.

5. Verfahren nach Anspruch 1, wobei die Dauer der Ultraschallerzeugung bestimmt ist, um das erste Material völli zu entfernen.

6. Verfahren nach Anspruch 1, wobei die Dauer der Ultraschallerzeugung bestimmt ist, um das erste Material ausgehend von freiliegenden Flächen des Letzteren zu entfernen.

7. Verfahren nach Anspruch 1, wobei die Dauer der Ultraschallerzeugung bestimmt ist, um die Oberflächenrauheit des ersten Materiales zu reduzieren.

8. Verfahren nach Anspruch 1, wobei die Dauer der Ultraschallerzeugung bestimmt ist, um die Dicke des ersten Materials zu reduzieren.

## Claims

1. Method for selectively etching a structure (1) comprising at least one first material to be etched (4) and at least one second material (2), comprising the following steps:
- choosing at least one chemical species capable of reacting with the first material (4) and of not reacting with the second material (3);
- choosing at least one soluble compound that does not react with said materials but which is able to release the aforementioned chemical species;
- producing a solution (11) containing said compound;
- immersing the structure (1) in the solution; and
- producing ultrasound in the solution at at least one frequency capable of generating cavitation bubbles such that the chemical species is generated and reacts selectively with the first material, while producing a soluble compound or a precipitate.

2. Method according to Claim 1, in which the ultrasound frequency lies between 100 kHz and 3 MHz.

3. Method according to Claim 1, in which the ultrasound frequency lies between 200 kHz and 600 kHz.

4. Method according to Claim 1, in which the solution is at a concentration of less than five moles per liter.

5. Method according to Claim 1, in which the period during which ultrasound is produced is determined in order to remove the first material completely.

6. Method according to Claim 1, in which the period during which ultrasound is produced is determined in order to remove the first material from uncovered surfaces of the latter.

7. Method according to Claim 1, in which the period during which ultrasound is produced is determined in order to reduce the roughness of the surface of the first material.

8. Method according to Claim 1, in which the period during which ultrasound is produced is determined in order to reduce the thickness of the first material.
